# FASCICULE DE BREVET EUROPEEN

(11) **EP 2 562 803 B1**
(45) Date de publication et mention de la délivrance du brevet: **16.07.2014**
(21) Numéro de dépôt: 12181053.5
(22) Date de dépôt: 20.08.2012
(51) Int. Cl.: H01L 21/8238, H01L 21/84, H01L 27/12, H01L 21/285, H01L 29/45, H01L 29/51, H01L 29/78, H01L 21/336

(54) **Procédé de réalisation d'un dispositif à transistors contraints à l'aide d'une couche externe, et dispositif**
Herstellungsverfahren für ein Bauelement mit mit Hilfe einer externen Schicht verspannten Transistoren, und Bauelement
Method for making a device comprising transistors strained by an external layer, and device

(30) Priorité: 25.08.2011 FR 1157530
(43) Date de publication de la demande: 27.02.2013
(73) Titulaire: Commissariat à l'Énergie Atomique et aux Énergies Alternatives, 75015 Paris (FR)
(72) Inventeur: Nemouchi, Fabrice, 38430 MOIRANS (FR); Gergaud, Patrice, 38500 LA BUISSE (FR); Poiroux, Thierry, 38500 VOIRON (FR); Previtali, Bernard, 38100 GRENOBLE (FR)
(74) Mandataire: Ilgart, Jean-Christophe

(56) Documents cités:
- JP-A- 11 067 694
- US-A- 5 989 965
- US-A1- 2006 220 113
- US-A1- 2007 066 001
- US-A1- 2008 173 908
- US-A1- 2009 050 972
- US-A1- 2009 104 746
- US-A1- 2009 140 396
- US-A1- 2011 084 320
- US-A1- 2011 159 654
- "APPLYING MECHANICAL STRESS TO IMPROVE MOS SEMICONDUCTOR PERFORMANCE", IBM TECHNICAL DISCLOSURE BULLETIN, INTERNATIONAL BUSINESS MACHINES CORP. (THORNWOOD), US, vol. 30, no. 9, 1 février 1988 (1988-02-01), pages 330-333, XP000104874, ISSN: 0018-8689

## Description

### DOMAINE TECHNIQUE

La présente demande concerne le domaine des dispositifs microélectroniques à transistors, et en particulier celui des transistors à canal contraint.

L'invention prévoit un procédé de réalisation d'un dispositif à transistors dans lequel certains transistors sont contraints notamment à l'aide d'une couche externe.

Elle trouve notamment des applications en particulier dans la réalisation de transistors de taille inférieure à 22 nm.

### ÉTAT DE LA TECHNIQUE ANTÉRIEURE

Les performances en courant des transistors à effet de champ sont liées notamment à la mobilité des porteurs de charge dans la zone de canal, les porteurs de charge étant des électrons pour les transistors de type N et des trous pour les transistors de type P.

Dans le canal d'un transistor, la vitesse de déplacement des porteurs de charge peut être améliorée en contraignant ce dernier. Appliquer une contrainte permet de réaliser une distorsion du réseau cristallin du matériau semi-conducteur et de modifier sa structure de bande et en particulier les propriétés de transport de charges.

Lorsqu'un canal est contraint en compression, cela favorise le déplacement de trous dans ce dernier tandis que lorsqu'un canal est contraint en tension, ce sont les électrons dont le déplacement est favorisé.

Pour obtenir un gain en performance des transistors PMOS on cherche donc généralement à les contraindre en compression, tandis qu'un gain en performance des transistors NMOS est obtenu en appliquant une contrainte en tension sur leurs canaux.

Différentes méthodes existent pour induire un état de contrainte dans le canal d'un transistor

Il est connu d'appliquer une contrainte sur le canal de transistors en déposant une couche de contrainte, prévue pour appliquer un type donné de contrainte, par exemple une contrainte en tension, sur les zones de source et de drain ainsi que sur la grille de ces derniers.

Cependant, dans le cas où l'on réalise un dispositif comprenant des transistors de types différents par exemple à la fois des transistors de type PMOS et des transistors de type NMOS, la contrainte est appliquée par la couche externe indifféremment sur tous les transistors, ce qui peut nuire au fonctionnement de certains transistors, par exemple aux transistors PMOS lorsque cette couche externe est prévue pour appliquer une contrainte en tension.

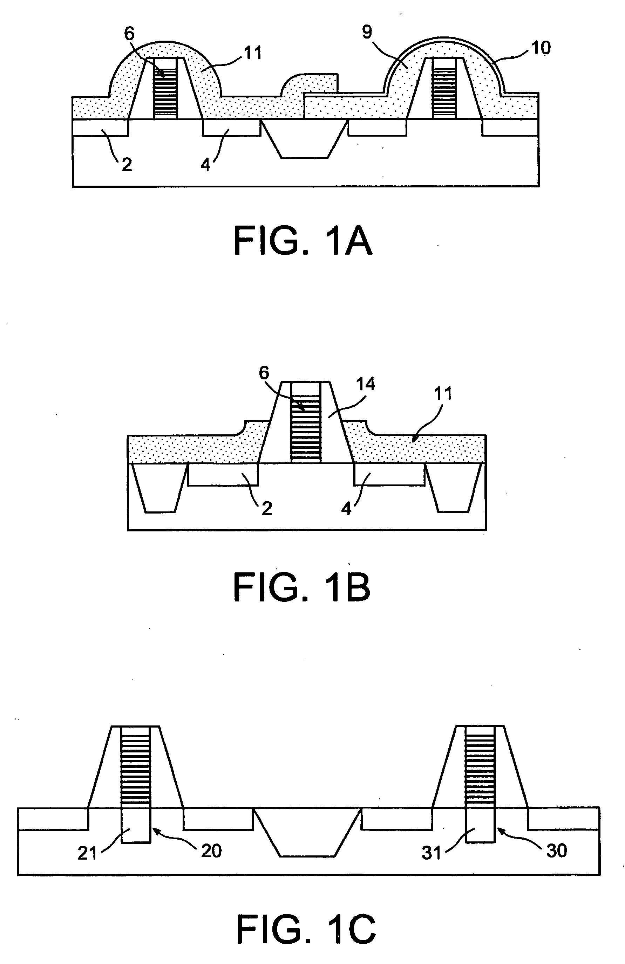

Les documents US 2007/0099360 A1 et US 2007/0287240 A1, divulguent des procédés de réalisation de transistors à canal contraint à l'aide d'une couche de nitrure de silicium 11 que l'on vient déposer sur les zones de source 2 et de drain 4 ainsi que sur la grille 6 du transistor (figures 1A et 1B).

La couche de contrainte à base de nitrure de silicium 11 peut être conservée sur la grille 6 (figure 1A) ou retirée du dessus de la grille 6 de manière à n'être en contact qu'avec les espaceurs 14 formés sur les flancs de la grille (figure 1B).

Pour permettre de former un dispositif doté à la fois de transistors contraints en tension et de transistors contraints en compression, on forme tout d'abord une première couche de nitrure de silicium 9 destinée à contraindre en tension sur l'ensemble des transistors.

Cette première couche de nitrure de silicium 9 est recouverte d'une couche d'arrêt de gravure 10, puis est retirée par gravure au dessus des transistors que l'on souhaite contraindre en compression. On dépose ensuite une deuxième couche de nitrure de silicium 11 destinée à contraindre en compression. Cette deuxième couche 11, est ensuite retirée de l'ensemble des transistors que l'on souhaite contraindre en tension, par gravure avec arrêt sur la couche d'arrêt 10 (figure 1A).

Il est également connu de former des transistors à canal contraint par une couche sous-jacente.

Le document US 2009/0085125A1, divulgue un dispositif doté d'un transistor dont le canal 20 est contraint par une couche sous jacente de matériau 21 (figure 1C). Un tel matériau 21 peut être par exemple à base de SiGe sur lequel on a fait croitre un canal de Si. Dans ce cas, on peut obtenir un canal 20 contraint en compression pour réaliser un transistor pMOS.

Le dispositif comprend un autre transistor dont le canal 30 est contraint par une autre couche sous jacente de matériau 31. Un tel matériau 31 peut être par exemple à base de SiC sur lequel on a fait croitre un canal de Si. Dans ce cas, on peut obtenir un canal 30 contraint en tension pour réaliser un transistor nMOS (figure 1C).

Un tel procédé nécessite de nombreuses étapes de photolithographie, de gravures ainsi que de dépôts par épitaxie pour mettre en oeuvre un tel dispositif.

Le document US 2011/0084320, divulgue un dispositif et un procédé de formation d'une couche de siliciure de métal. Un espace vide est créé par la séparation d'une couche superficielle rendue amorphe.

Une source de métal pénètre dans l'espace vide, et un traitement thermique convertit le métal dans l'espace vide en siliciure de métal.

Il se pose le problème de trouver un nouveau procédé de réalisation d'un dispositif microélectronique à transistors dotés d'un canal contraint.

### EXPOSÉ DE L'INVENTION

La présente invention concerne un procédé de réalisation d'un dispositif microélectronique à transistors comprenant des étapes de :
a) formation d'une couche de contrainte sur un premier bloc de grille d'un transistor d'un premier type, en particulier de type PMOS ou NMOS, et sur des premières zones semi-conductrices situées de part et d'autre dudit premier bloc de grille, ainsi que sur un deuxième bloc de grille d'un deuxième transistor d'un deuxième type, différent du premier type, en particulier de type NMOS ou PMOS, et sur des deuxièmes zones semi-conductrices situées de part et d'autre dudit deuxième bloc de grille, une couche sacrificielle étant prévue entre ladite couche de contrainte et lesdites deuxièmes zones semi-conductrices du transistor du deuxième type,
b) former des ouvertures traversant la couche de contrainte parmi lesquelles, une ou plusieurs ouvertures données dévoilant la couche sacrificielle,
c) retrait de la couche sacrificielle par gravure à travers lesdites ouvertures.

Ainsi, on forme une couche de contrainte sur un ensemble de transistors du dispositif et on libère la contrainte exercée sur au moins un transistor donné de cet ensemble par retrait d'une couche sacrificielle située entre ledit transistor donné et ladite couche de contrainte. De cette manière, on sépare la couche de contrainte et le transistor donné.

Avec un tel procédé, on peut ainsi contraindre des transistors d'un type donné à l'aide de la couche externe de contrainte, et libérer de cette contrainte des transistors d'un autre type tout en conservant cette couche qui peut également remplir d'autre fonctions, par exemple servir de couche d'arrêt de gravure et/ou d'isolation.

Selon une possibilité de mise en oeuvre, parmi les ouvertures formées à l'étape b) peuvent figurer une ou plusieurs ouvertures dévoilant les premières zones semi-conductrices.

Ainsi, en même temps qu'on dévoile la couche sacrificielle, on dévoile les premières zones semi-conductrices, ce qui peut, par exemple, permettre ultérieurement de réaliser une siliciuration et/ou des zones de prises de contacts sur les premières zones semi-conductrices.

Le procédé peut comprendre en outre, après l'étape c), le dépôt d'un matériau métallique à travers lesdites ouvertures, suivi d'un recuit, de manière à former des zones d'alliage de métal et de semi-conducteur, en particulier des zones siliciurées dans un cas où les premières et les deuxièmes zones semi-conductrices sont à base de silicium.

Cette étape de siliciuration est réalisée après l'ouverture des contacts ce qui permet de décaler les budgets thermiques de la siliciuration à l'étape de la formation des contacts.

Lors dudit dépôt de matériau métallique, le type de matériau métallique déposé, le volume de matériau métallique déposé sur les premières zones semi-conductrices, ainsi que la durée du recuit sont choisis de manière à former des premières zones d'alliage de métal et semi-conducteur exerçant une contrainte en compression, en particulier sur une zone de canal dudit transistor du premier type.

Le retrait de la couche sacrificielle par gravure à travers lesdites ouvertures données peut conduire à la formation de cavités entre lesdites deuxièmes zones semi-conductrices et ladite couche de contrainte, ledit dépôt métallique et ledit recuit étant réalisés de manière à former des deuxièmes zones d'alliage de métal et de semi-conducteur comblant partiellement lesdites cavités, un espace étant conservé entre lesdites deuxièmes zones d'alliage de métal et de semi-conducteur et ladite couche de contrainte.

Ainsi, on peut siliciurer les premières et deuxièmes zones semi-conductrices, sans contraindre ou en limitant une contrainte sur la zone de canal du transistor du deuxième type résultant de cette siliciuration.

Selon une possibilité de mise en oeuvre, le premier bloc de grille et le deuxième de bloc de grille peuvent reposer sur une couche semi-conductrice, les premières zones semi-conductrices et/ou les deuxièmes zones semi-conductrices étant formées par croissance sur ladite couche semi-conductrice.

On peut également réaliser préalablement à ladite croissance : un amincissement de ladite couche semi-conductrice dans des zones situées de part et d'autres dudit premier bloc de grille et/ou de dudit deuxième bloc de grille.

Cela permet, d'obtenir, une fois la croissance réalisée, des premières zones semi-conductrices en contact avec une zone de la couche semi-conductrice destinée à former un canal du transistor du premier type et/ou des deuxièmes zones semi-conductrices en contact avec une zone de la couche semi-conductrice destinée à former un canal du transistor du deuxième type.

Selon une possibilité de mise en oeuvre du procédé, les premières zones semi-conductrices peuvent être formées d'un matériau semi-conducteur prévu pour contraindre en compression ladite couche semi-conductrice sur laquelle repose ledit premier bloc de grille. Les premières zones semi-conductrices peuvent être formées par exemple à base de SiGe, en particulier lorsque la couche semi-conductrice est à base de Si.

Dans le cas où un amincissement de cette couche semi-conductrice a été réalisé au préalable, une contrainte en compression peut être exercée sur la zone de canal sur laquelle repose le premier bloc de grille.

Selon une possibilité de mise en oeuvre du procédé, les deuxièmes zones semi-conductrices peuvent être formées d'un matériau semi-conducteur prévu pour contraindre en tension ladite couche semi-conductrice sur laquelle repose ledit deuxième bloc de grille. Les deuxièmes zones semi-conductrices peuvent être formées par exemple à base de SiC en particulier lorsque la couche semi-conductrice est à base de Si.

Dans le cas où un amincissement de cette couche semi-conductrice a été réalisé au préalable, une contrainte en tension peut être exercée sur la zone de canal sur laquelle repose le deuxième bloc de grille.

Préalablement à l'étape a), des espaceurs isolants peuvent être formés contre ledit premier bloc de grille et ledit deuxième bloc de grille. Dans ce cas ladite couche de contrainte peut reposer sur lesdits espaceurs.

Selon une possibilité, la couche de contrainte peut être séparée desdites deuxièmes zones semi-conductrices par une couche d'arrêt de gravure.

Dans ce cas, le retrait à l'étape c) de la couche sacrificielle par gravure à travers lesdites ouvertures données peut être réalisé jusqu'à atteindre ladite couche d'arrêt de gravure.

La couche de contrainte peut être base d'un matériau diélectrique tel qu'un nitrure de silicium SiₓN_{y}.

Selon une possibilité de mise en oeuvre, le procédé peut comprendre entre l'étape a) et l'étape b), des étapes de :
- dépôt d'au moins une couche isolante sur la couche de contrainte,
- formation de trous traversant ladite couche isolante et dévoilant ladite couche de contrainte par gravure sélective de ladite couche isolante vis-à-vis de ladite couche de contrainte.

Selon une possibilité de mise en oeuvre, le premier bloc de grille et/ou ledit deuxième bloc de grille peuvent être sacrificiel(s) et à base d'au moins un matériau sacrificiel destiné à être retiré. Dans ce cas, le procédé comprend en outre, après l'étape c), des étapes de :
- retrait de la couche de contrainte sur ledit premier bloc de grille et/ou sur ledit deuxième bloc de grille de manière à dévoiler ledit matériau sacrificiel,
- retrait dudit matériau sacrificiel,
- remplacement dudit matériau sacrificiel par au moins un autre matériau de grille.

La présente invention prévoit également un dispositif obtenu à l'aide d'un procédé tel que défini plus haut.

La présente invention prévoit également un dispositif microélectronique à transistors comprenant :
- un premier transistor doté de premières zones semi-conductrices situées de part et d'autre d'un premier bloc de grille, une couche de contrainte disposée sur et en contact avec le premier bloc de grille et sur les premières zones semi-conductrices de manière à exercer une contrainte mécanique donnée sur le premier transistor,
- un deuxième transistor doté de deuxièmes zones semi-conductrices situées de part et d'autre d'un deuxième bloc de grille, la couche de contrainte étant disposée au dessus du deuxième bloc de grille et des deuxièmes zones semi-conductrices et étant disjointe des deuxièmes zones semi-conductrices.

Ainsi, la couche de contrainte n'exerce pas de contrainte sur les deuxième zones semi-conductrices du deuxième transistor ou une contrainte inférieure à la contrainte mécanique donnée.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1C donnent des exemples de dispositifs microélectronique à transistors suivant l'art antérieur dotés de transistors PMOS et NMOS contraints respectivement, en compression et en tension,
- les figures 2A-2K illustrent un exemple de procédé suivant l'invention de dispositifs microélectronique à transistors contraints en compression et en tension,

- les figures 3A-3B illustrent une variante de procédé lors de laquelle on forme des grilles sacrificielles puis on remplace ces grilles sacrificielles par un matériau de grille,
- les figures 4A-4B illustrent une variante de procédé lors de laquelle on conserve le métal déposé après siliciuration,
- les figures 5A-5D et 6 illustrent une variante de procédé de réalisation d'un dispositif microélectronique suivant l'invention pour laquelle une couche de contrainte est déposée sur des transistors de types différents, au moins un transistor étant préalablement recouvert d'une couche sacrificielle recouvrant ses zones de source et de drain ainsi que sa grille.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

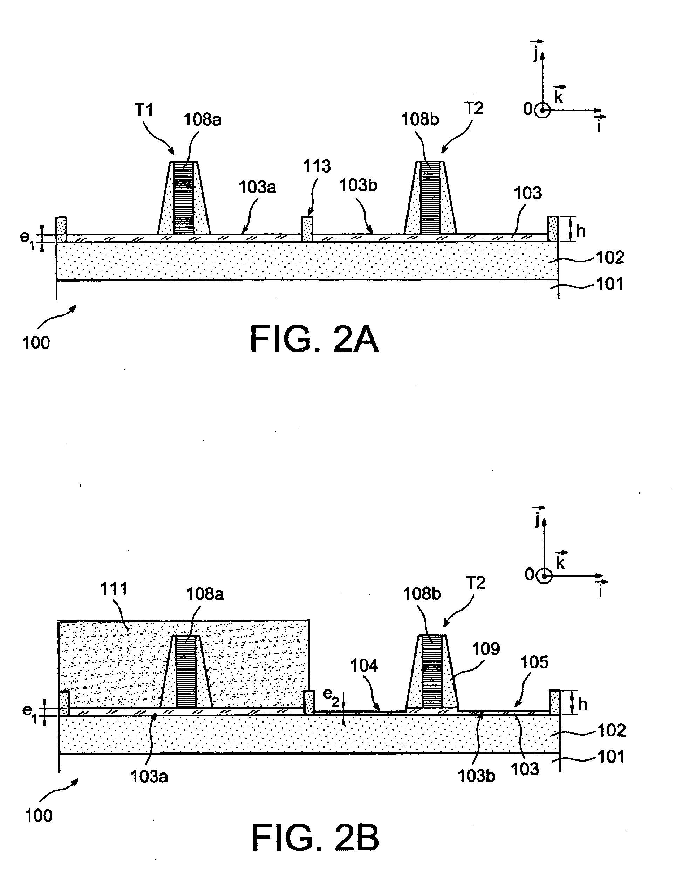

Un exemple de procédé suivant l'invention, de réalisation d'un dispositif microélectronique à transistors dont le canal est contraint, va à présent être décrit en liaison avec les figures 2A-2K.

Le matériau de départ peut être un substrat 100, par exemple de type SOI (SOI pour Silicon On Insulator ou « silicium sur isolant ») formé d'une couche de support 101 semi-conductrice, d'une couche isolante 102 recouvrant la couche de support 101 et d'une fine couche semi-conductrice 103 sur la couche isolante 102. La couche isolante 102 du substrat 100 peut être par exemple un oxyde de silicium enterré de type ultra mince ou UTBox (UTBox pour « Ultra Thin Burried oxide ») d'une épaisseur comprise par exemple entre 5 nm et 145 nm.

Sur le support 100, une première grille 108a d'un transistor T1 d'un premier type, par exemple de type PMOS reposant sur une première région 103a de la fine couche semi-conductrice 103 ainsi qu'une deuxième grille 108b d'un transistor d'un deuxième type, par exemple de type NMOS, reposant sur une deuxième région 103b de la fine couche semi-conductrice 103, sont formées.

Des zones d'isolation 113 de type STI (STI pour « shallow Trench Isolation » ou tranchées d'isolation peu profondes) peuvent être également prévues entre les transistors T1 et T2, afin d'isoler électriquement ces derniers entre eux (figure 2A).

Ces zones d'isolation 113 STI peuvent être prévues de manière à dépasser de l'épaisseur de la fine couche semi-conductrice 103. La fine couche semi-conductrice 103 peut être prévue avec une épaisseur e₁ (mesurée sur la figure 2B dans une direction parallèle au vecteur *̅j̅*̅ du repère orthogonal [O; *̅i̅*̅ ; *̅j̅*̅ ; *̅k̅*̅]) comprise par exemple entre 5 nm et 50 nm et préférentiellement entre 5 nm et 10 nm, tandis que les zones d'isolation 113 STI peuvent être prévues avec une hauteur h (également mesurée sur la figure 2B dans une direction parallèle au vecteur *̅j̅*̅) comprise par exemple entre 10 nm et 100 nm.

Les zones d'isolation 113 STI peuvent être prévues de manière à dépasser de l'épaisseur de la fine couche semi-conductrice 103 d'une épaisseur E = h-e1 prédéterminée, prévue notamment en fonction de celles de zones semi-conductrices destinées à être réalisées ultérieurement et prévues pour former des régions de source et de drain des transistors T1 et T2.

Ensuite, on peut éventuellement retirer des portions de la deuxième région 103b de part et d'autre de la deuxième grille 108b, de manière à amincir la deuxième région 103b semi-conductrice de la couche semi-conductrice 103 dans des zones 104, 105, destinées à former une source et un drain du deuxième transistor T2. Après amincissement, les flancs d'une zone de canal située sous la grille 108b sont dévoilés.

Pour cela, des étapes de dépôt d'une couche de masquage, par exemple une couche de masque dur à base de nitrure de silicium, puis de photolithographie et de gravure, peuvent être prévues pour former un masque dur 111 recouvrant la première grille 108a ainsi que la première région semi-conductrice 103a. La seconde grille 108b et la seconde région semi-conductrice 103b sont quant à elles dévoilées.

L'amincissement des zones 104, 105 de la deuxième région semi-conductrice 103b peut être effectué par exemple par gravure. Cet amincissement peut être effectué de manière à conserver une épaisseur comprise par exemple entre 3 nm et 10 nm de matériau semi-conducteur. Lors de l'amincissement de la deuxième région semi-conductrice 103b, la zone de canal située sous la deuxième grille 108b peut être protégée par une zone de diélectrique de grille, ainsi que par des espaceurs isolants 109 accolés contre la deuxième grille 108b. On peut ainsi conserver une épaisseur e1 pour la zone de canal supérieure à celle e2 des zones 104, 105 de la région semi-conductrice 103b destinées à appartenir, respectivement, à une zone de source et à une zone de drain du deuxième transistor T2 (figure 2B).

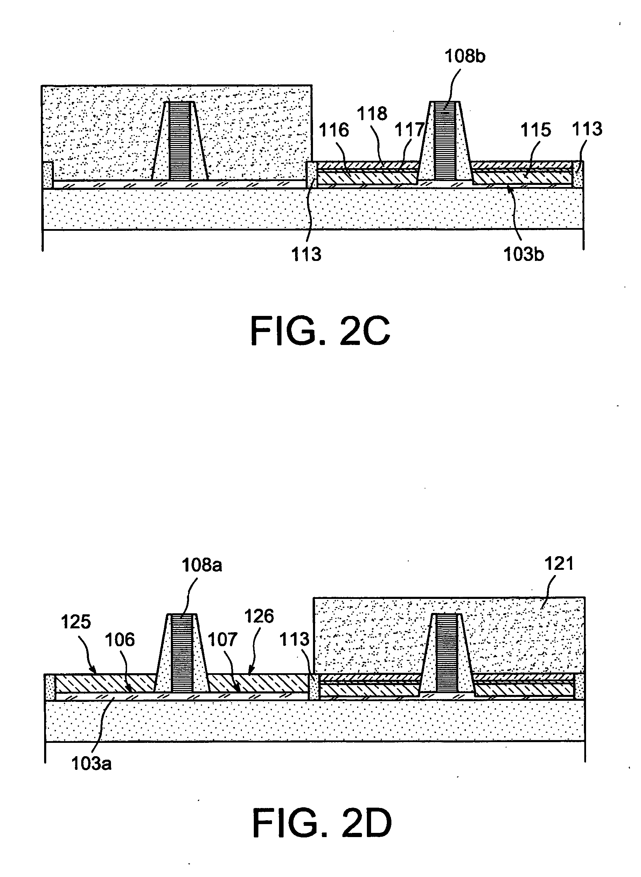

Ensuite, on forme des zones semi-conductrices 115, 116 sur la deuxième région semi-conductrice 103b, de part et d'autre de la grille (figure 2C).

Ces zones semi-conductrices 115, 116 peuvent être réalisées par une croissance par épitaxie.

Le matériau semi-conducteur des zones 115, 116 peut être choisi de manière à avoir un paramètre de maille inférieur à celui du matériau semi-conducteur de la deuxième région semi-conductrice 103b. Dans ce cas, les zones semi-conductrices 115, 116 réalisées exercent une contrainte sur la zone semi-conductrice 103b, en particulier une contrainte en tension sur la zone de canal du transistor T2.

Lorsque le matériau semi-conducteur de la couche semi-conductrice 103 est du silicium, le matériau des zones semi-conductrices 115, 116 peut être par exemple du SiC dont l'épaisseur peut être comprise par exemple entre 5 nm et 30 nm.

Puis, une couche d'arrêt 117 de gravure est déposée sur les zones semi-conductrices 115, 116. Cette couche d'arrêt 117 peut être formée par exemple à base de SiGe selon une épaisseur par exemple de l'ordre de 1 nm.

On forme ensuite une couche sacrificielle 118. Le matériau de la couche sacrificielle 118 peut être un matériau choisi de manière à pouvoir être gravé sélectivement vis-à-vis de celui d'une couche dite « de contrainte », destinée à être réalisée ultérieurement.

La couche sacrificielle 118 peut être également formée avec une épaisseur prédéterminée en fonction d'une étape de siliciuration destinée à être réalisée ultérieurement. La couche sacrificielle 118 peut par exemple être formée par épitaxie. La couche sacrificielle 118 peut être à base de Si selon une épaisseur par exemple comprise entre 5 nm et 10 nm (Figure 2C).

Selon une possibilité de mise en oeuvre, l'épaisseur cumulée de chaque zone semi-conductrice 115, 116, de la couche d'arrêt de gravure 117 et de la couche sacrificielle 118 peut être prévue de sorte que le sommet des zones d'isolation et une face dévoilée de la couche sacrificielle 117 sont à la même hauteur ou sensiblement à la même hauteur.

Le masque dur 111 peut être ensuite retiré.

Puis, des étapes de dépôt d'une couche de masquage, par exemple une couche de masque dur à base de nitrure de silicium, puis de photolithographie et de gravure, peuvent être prévues pour former un autre masque dur 121 recouvrant la deuxième grille 108b ainsi que les zones semi-conductrices 115, 116. La première grille 108a et la première région semi-conductrice 103a sont quant à elles dévoilées.

Une étape d'amincissement de zones 106, 107 de la première région semi-conductrice 103a situées de part et d'autre de la grille 108a du premier transistor T1 peut être également effectuée (cette étape n'étant pas représentée sur la figure 2D).

Ensuite, on forme des zones semi-conductrices 125, 126 sur la première région semi-conductrice 103a. Ces zones semi-conductrices 125, 126 peuvent être réalisées par épitaxie, avec une épaisseur comprise par exemple entre 5 nm et 30 nm.

Le matériau des zones 125, 126 peut être un semi-conducteur choisi de manière à avoir un paramètre de maille supérieur à celui du matériau semi-conducteur de la première région semi-conductrice 103a (figure 2D).

Dans ce cas, les zones semi-conductrices 125, 126 exercent une contrainte en compression sur la région semi-conductrice 103a, et en particulier sur la zone de canal du transistor T1.

Lorsque le matériau semi-conducteur de la couche semi-conductrice 103 est du silicium, le matériau des zones semi-conductrices 125, 126 peut être par exemple du SiGe dont l'épaisseur peut être comprise par exemple entre 5 nm et 30 nm.

On réalise ensuite un retrait dudit autre masque dur 121.

Puis, on forme une couche 130 dite « de contrainte », prévue pour exercer une contrainte sur le canal de certains transistors du dispositif. La couche 130 de contrainte peut être prévue en particulier pour exercer une contrainte sur le canal de transistors d'un type donné, par exemple sur le premier transistor T1 de type PMOS.

Cette couche 130 de contrainte peut être à base d'un nitrure de silicium SiₓN_{y} formé par dépôt.

Suivant le ratio des précurseurs choisis, on peut modifier la stoechiométrie du nitrure de silicium. Le nitrure de silicium est généralement déposé par CVD (Chemical Vapor deposition) en utilisant deux précurseurs : Silane (SiH₄) et Azote (N₂). Lors du dépôt de cette couche, la contraintre en compression ou en tension peut être modulée avec la stoechiometrie du nitrure de silicium, donc du ratio des précurseurs, et ceci pour une température donnée, typiquement entre 400°C et 550°C. Lorsque cette couche est destinée à exercer une contraintre en compression, en particulier pour le premier transistor de type PMOS, le nitrure de silicium est plus riche en azote. Au contraire, lorsque que cette couche est destinée à exercer une contraintre en tension, en particulier pour le second transistor de type NMOS, le nitrure de silicium est plus riche en silicium.

Lors du dépôt de la couche de contrainte, le précurseur ainsi que la température de dépôt peuvent être adaptés pour former soit une couche de contrainte à base d'un nitrure de silicium donné destinée à exercer une contrainte en compression, en particulier lorsque le premier transistor est de type PMOS, ou bien former une couche de contrainte à base d'un autre nitrure de silicium et destiné à exercer une contrainte en tension, en particulier lorsque le premier transistor est de type NMOS. La couche de contrainte 130 peut avoir une épaisseur par exemple comprise entre 5 et 50 nm et par exemple de l'ordre de 20 nm.

Cette couche de contrainte 130 peut être également prévue pour jouer le rôle de couche d'arrêt de gravure pour au moins une étape de gravure destinée à être réalisée ultérieurement.

La couche 130 de contrainte peut être déposée de manière conforme sur l'ensemble des transistors T1 et T2 et à recouvrir les grilles 108a, 108b ainsi que les zones semi-conductrices 125, 126, 115, 116 formées de chaque côté des grilles 108a, 108b.

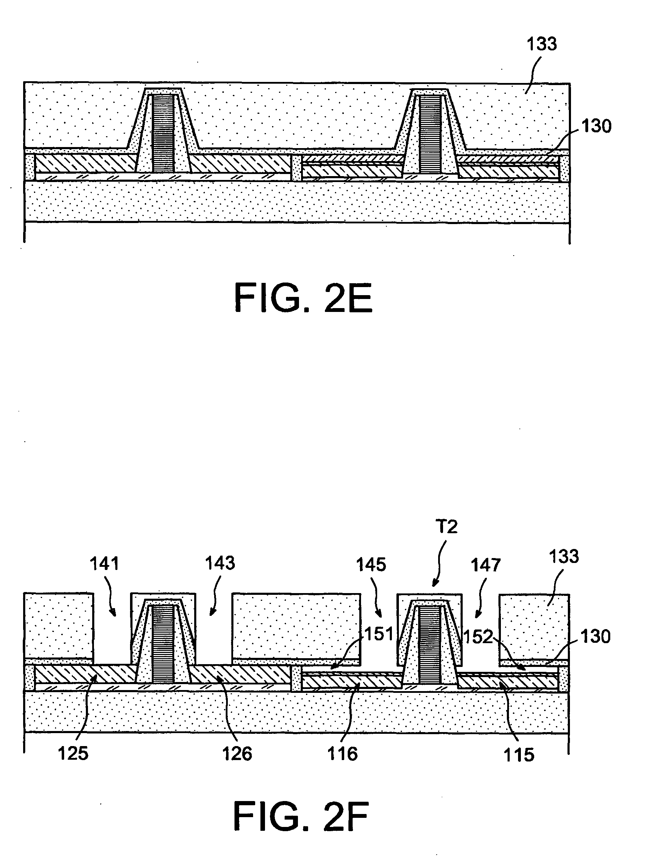

Puis, on forme une couche de matériau diélectrique 133 de manière à recouvrir les grilles 108a, 108b. On peut aplanir ensuite cette couche de matériau diélectrique 133, par exemple par un procédé de polissage mécano-chimique. Le matériau diélectrique 133 peut être choisi de manière à pouvoir être gravé sélectivement vis-à-vis de celui de la couche de contrainte 130. Le matériau diélectrique 133 peut être par exemple du SiO₂ lorsque la couche de contrainte est à base d'un nitrure de silicium tel que du Si₃N₄ (Figure 2E).

On réalise ensuite des ouvertures 141, 143, 145, 147, traversant les couches 130 et 133, et qui sont destinées à accueillir des plots de contact de source et de drain du premier transistor T1 et du deuxième transistor T2. Cela peut être effectué par gravure sélective de la couche de matériau diélectrique 133 avec arrêt sur la couche 130 de contrainte.

Puis, on prolonge les ouvertures 141, 143, 145, 147, en réalisant une gravure de la couche 130 de contrainte, avec arrêt sur la couche sacrificielle 117, ou éventuellement sur la couche d'arrêt de gravure 118.

La couche sacrificielle 117 est également retirée. Le retrait de la couche sacrificielle 117 peut être réalisé par exemple par gravure à l'aide d'une solution de TMAH.

Ce retrait conduit à la formation de cavités 151, 152 entre la couche 130 de contrainte et les zones semi-conductrices 115, 116 du deuxième transistor T2. Le volume de ces cavités 151, 152, qui dépend notamment de l'épaisseur de la couche sacrificielle, peut être prévu en fonction d'une étape de siliciuration destinée à être réalisée ultérieurement. Le retrait de la couche sacrificielle 118 permet un relâchement de la contrainte qui était exercée par la couche de contrainte 130 sur le deuxième transistor T2 de type NMOS (Figure 2F).

La couche sacrificielle 118 peut être par exemple à base de Si tandis que la couche d'arrêt peut être à base de SixGey. Il est dans ce cas possible de graver cette couche sacrificielle 118 à l'aide d'une solution à base de TMAH, par exemple une solution contenant 25 % de TMAH afin d'obtenir une sélectivité de l'ordre de 30 entre le silicium et du Si_{0.7}Ge_{0.3} de la couche d'arrêt 117. Ainsi, avec une telle sélectivité, le retrait d'une couche sacrificielle 118 de Si d'une épaisseur par exemple de l'ordre de 30 nm engendre une consommation du Si_{0.7}Ge_{0.3} de la couche d'arrêt 117 d'au plus 1 nm.

La couche d'arrêt 117 de gravure, peut être retirée ensuite par gravure sélective vis-à-vis du matériau des zones semi-conductrices 125 et 126, et de la couche 130 de contrainte. Une telle gravure sélective permet de ne pas consommer le matériau semi-conducteur des zones semi-conductrices 125 et 126 destinées à former des zones de sources et de drain du deuxième transistor T2.

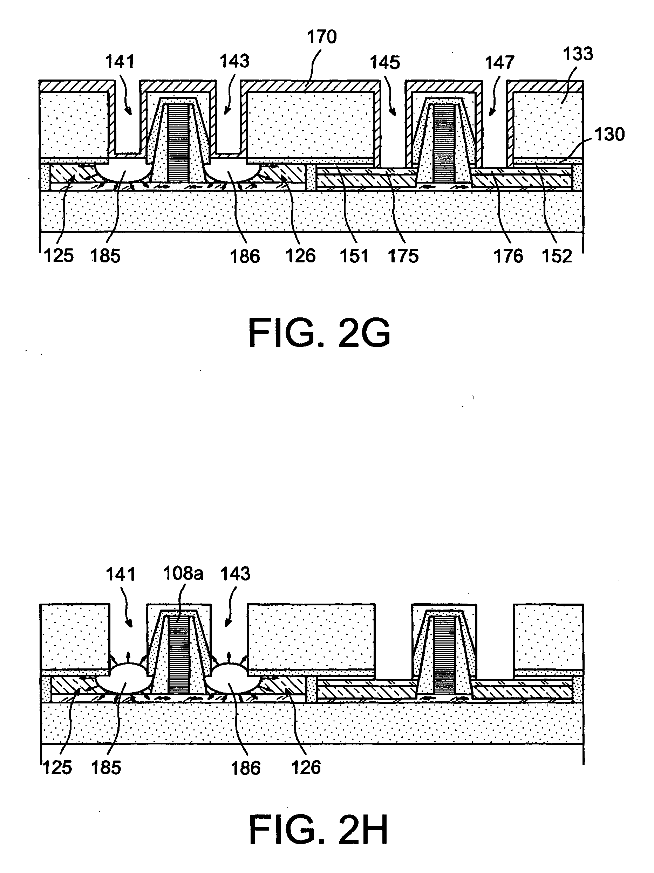

On effectue ensuite une siliciuration des zones semi-conductrices 115 et 116 dévoilées par les ouvertures 145, 147, formées de part et d'autre de la grille 108b du deuxième transistor T2, ainsi que des zones semi-conductrices 125 et 126 dévoilées par les ouvertures 141, 143 formées de part et d'autre de la grille 108a du premier transistor T1 (figure 2G).

Cette siliciuration peut être réalisée par dépôt d'un matériau métallique 170 réagissant avec le matériau semi-conducteur respectif des zones semi-conductrices 115, 116 d'une part et 125 et 126 d'autre part.

Le matériau métallique 170 peut être constitué d'un métal ou d'un alliage de métaux choisi(s) parmi un ou plusieurs des métaux de transition ou les terres rares suivants : nickel, palladium, platine, titane, Cobalt, Erbium, Ytterbium, peut être mis en oeuvre. Le dépôt peut être non conforme, de sorte que l'épaisseur maximale de matière déposée se trouve en surface sur des zones parallèles au plan principal du substrat 100 (défini comme sur la figure 2B dans une direction parallèle au vecteur *̅j̅*̅ du repère orthogonal [O; *̅i̅*̅ ; *̅j̅*̅ ; *̅k̅*̅]) et au fond des ouvertures 141, 143, 145, 147, tandis que l'épaisseur de matière déposée est minimale sur les parois des ouvertures 141, 143, 145, 147. Le dépôt peut être par exemple de type PVD (PVD pour « Physical Vapor Deposition »), selon une épaisseur de métal qui peut être comprise par exemple entre 1 nm et 10 nm, par exemple de l'ordre de 5 nm.

Au niveau du deuxième transistor T2, le matériau métallique 170 peut être déposé dans les ouvertures 145, 147 de manière à ne remplir que partiellement les cavités 151, 152.

Un ou plusieurs recuits de siliciuration peu(ven)t être ensuite réalisé(s) par un procédé de recuit rapide (communément appelé en anglais *« Rapide Thermal Process »* ou « RT ») à une température comprise par exemple entre 200°C et 800°C et par exemple préférentiellement entre 350°C et 450°C conduit à la réaction entre le silicium et le métal formant un siliciure (Figure 2G).

Lors de la siliciuration, des zones de siliciure 175, 176, 185, 186, peuvent se former soit dans le métal déposé par diffusion du matériau semi-conducteur soit dans le matériau semi-conducteur par diffusion du métal à l'interface entre le matériau métallique et les zones 175, 176, 185, 186, d'alliage semi-conducteur/métal ou entre zones 175, 176, 185, 186, d'alliage semi-conducteur/métal et matériau semi-conducteur, une augmentation de volume se produit.

Cela entraine, au fond des ouvertures 141, 143, réalisées de part et d'autre de la grille 108a du premier transistor T1, l'apparition de contraintes en compression au niveau des zones 185, 186 d'alliage métal/semi-conducteur. Les zones 185, 186 d'alliage métal/semi-conducteur peuvent exercer une contrainte au niveau des zones destinées à jouer le rôle de sources et de drains du premier transistor T1 et des espaceurs qui se répercute et au niveau du canal. La présence d'une couche sur les zones semi-conductrices 125, 126 à base d'un matériau qui n'est pas semi-conducteur, par exemple d'un matériau isolant, permet de maintenir la contrainte formée par siliciuration.

Des zones siliciurées 175, 176 sont également formées au niveau des zones semi-conductrices destinées à jouer le rôle de sources et drains du deuxième transistor T2 de type nMOS.

Malgré une augmentation de volume des zones siliciurées 175, 176, les cavités 151, 152 précédemment formées par gravure de la couche sacrificielle 117 sont prévues de sorte qu'après siliciuration, un espace 161 restant est maintenu entre les zones siliciurées 175, 176 et la couche de contrainte 130. On limite ainsi, voire on empêche des contraintes en compression sur la zone de canal du deuxième transistor T2 de type NMOS (figure 2G).

Une contrainte supérieure à -2 GPa peut être mise en oeuvre sur le premier transistor T1.

Dans le cas, par exemple, où l'on forme un siliciure à base de Pd₂Si, la variation de volume entre le siliciure et le silicium peut être de l'ordre de 209 %, ce qui peut induire une contrainte triaxiale de -50 GPa.

Pour des volumes donnés de matériau semi-conducteur et de matériau métallique déposé, une contrainte maximale peut être atteinte lorsque tout le matériau métallique 170 déposé a été consommé.

Une relaxation de la contrainte peut être prévue et modulée en fonction du temps prévu pour le recuit.

Il est donc possible de contrôler le niveau de contrainte au niveau des zones siliciurées 185, 186 notamment en ajustant le temps de recuit ou/et la température de recuit. Ce niveau de contrainte dépend également du type de matériau métallique 170 ainsi que des volumes respectifs de matériau semi-conducteur des zones 125, 126 et du matériau métallique 170 déposé.

Le tableau ci-dessous donne des variations de volume lors d'une réaction de siliciuration à l'état solide avec des volumes normalisés par unité de métal.

| **Métal** | **Silicium** | **Siliciure** | **Siliciure / (métal +silicium)** | **Siliciure / espèce la moins mobile** |
|---|---|---|---|---|
| Ti | 2Si | TiSi₂ | | TiSi₂ / Ti |
| 1.00 | 2.24 | 2.50 | 0.77 | 2.50 |
| 2 Pd | Si | Pd₂Si | | Pd2Si / Si |
| 1.00 | 0.68 | 1.42 | 0.84 | 2.09 |
| Pt | Si | PtSi | | PtSi / Si |
| 1.00 | 1.35 | 1.98 | 0.84 | 1.49 |
| 2 Co | Si | Co₂Si | | Co2Si / Si |
| 1.00 | 0.91 | 1.47 | 0.77 | 1.47 |
| Ni | Si | NiSi | | NiSi / Si |
| 1.00 | 1.83 | 2.18 | 0.77 | 1.20 |
| Ni | Si | NiSi₂ | | NiSi2 / Si |
| 1.00 | 3.66 | 3.59 | 0.76 | 0.99 |
| Ta | 2Si | TaSi₂ | | TaSi₂ / Ta |
| 1.00 | 2.21 | 2.40 | 0.75 | |
| Mo | 2Si | MoSi₂ | | MoSi₂ / Mo |
| 1.00 | 2.57 | 2.60 | 0.73 | |
| W | 2Si | WSi₂ | | WSi₂ / W |
| 1.00 | 2.52 | 2.58 | 0.73 | |

Le choix du matériau métallique 170 déposé et du siliciure que l'on souhaite former, peut être également fait par exemple selon l'application prévue pour le dispositif à transistors, et/ou en fonction du noeud technologique, c'est-à-dire de la taille prévue pour les transistors du dispositif.

Par exemple, pour des noeuds technologique C0 = 45nm et C0 = 32nm, on peut être choisir de réaliser des zones siliciurées de PtSi et de NiSi, même si, parmi les siliciures répertoriés dans le tableau donné plus haut le changement de volume qu'ils occasionnent et donc la contrainte qu'ils sont susceptibles d'induire n'est pas nécessairement la plus importante.

Le choix du matériau métallique 170 ainsi que du siliciure que l'on forme peut dépendre également des difficultés de mise en oeuvre du procédé de réalisation par exemple des étapes de traitements thermiques associées, de nettoyage, de gravure à mettre en oeuvre.

Le choix du matériau métallique 170 peut être également fait selon un critère mécanique, c'est à dire en fonction de l'intensité de la contrainte que l'on souhaite exercer sur les zones 185, 186.

La formation d'un siliciure par réaction entre le matériau métallique 170 et du silicium conduit à une consommation en silicium différente selon le matériau métallique 170 déposé. L'épaisseur du matériau métallique 170 peut être ainsi prévue en fonction de cette consommation.

Comme cela a été indiqué auparavant, en ajustant le temps de recuit, on peut ajuster la relaxation du siliciure formé.

Une fois les zones siliciurées 175, 176, 185, 186 réalisées, on peut effectuer un retrait sélectif du métal n'ayant pas réagit.

Le cas d'un retrait sélectif est illustré sur la figure 2H. Le métal en excès est sélectivement retiré par immersion dans une solution chimique chauffée dont la composition, les concentrations et la température sont choisies en fonction du métal précédemment déposé.

Le temps d'immersion est ajusté afin de permette à la solution d'accéder au métal au fond des ouvertures 141, 143, 145, 147. Par exemple, lorsque le métal déposé est du Ni, la solution utilisée peut être par exemple à base de H₂SO₄ et de H₂O₂.

Une couche barrière de diffusion 190 peut être ensuite déposée. Cette couche barrière 190 de diffusion peut être par exemple à base de TiN ou de TaN et avoir une épaisseur comprise par exemple entre 1 nm et 10 nm.

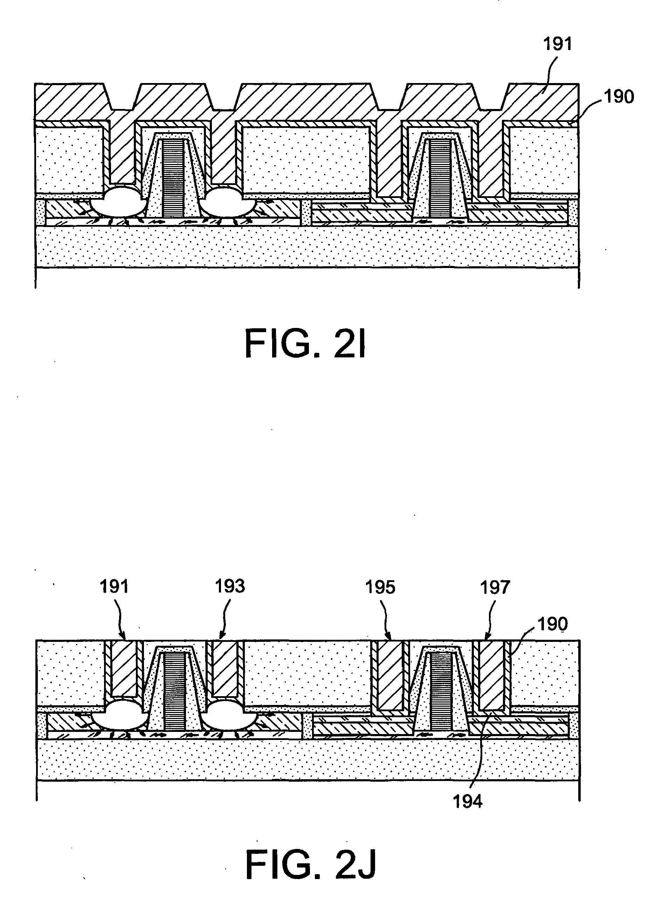

Un dépôt d'un matériau métallique 194 est ensuite effectué de manière à combler les ouvertures 141, 143, 145, 147. Ce matériau métallique 194 peut être par exemple du Tungstène, ou du Cuivre (Figure 2I).

Le matériau métallique 194 en excès ainsi que la couche barrière 190 sont ensuite ôtés lors d'étapes de polissage mécano-chimique avec un arrêt sur la couche de matériau diélectrique 133. Cela permet de former des plots de contact 191, 193, 195, 197 (Figure 2J) qui peuvent être prévus pour connecter les transistors T1, T2 avec un ou plusieurs niveaux d'interconnections.

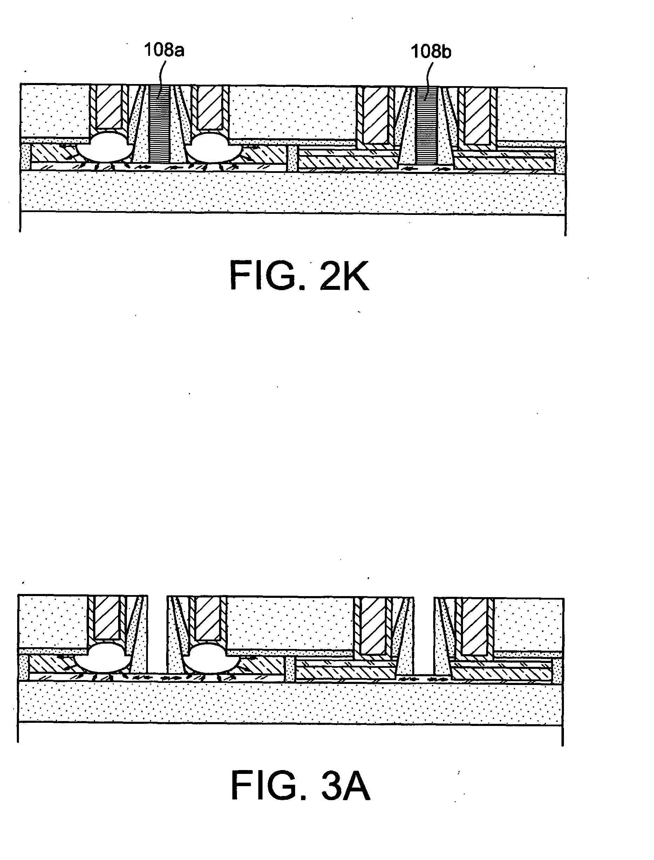

Selon une possibilité de mise en oeuvre, le procédé peut comprendre en outre une étape consistant à dévoiler le dessus de la grille 108a du premier transistor T1 ainsi que celui de la grille 108b du deuxième transistor T2 (figure 2K).

Un accès aux grilles 108a, 108b est ainsi réalisé. On peut ensuite former un ou plusieurs niveaux d'interconnexion par-dessus les transistors T1 et T2.

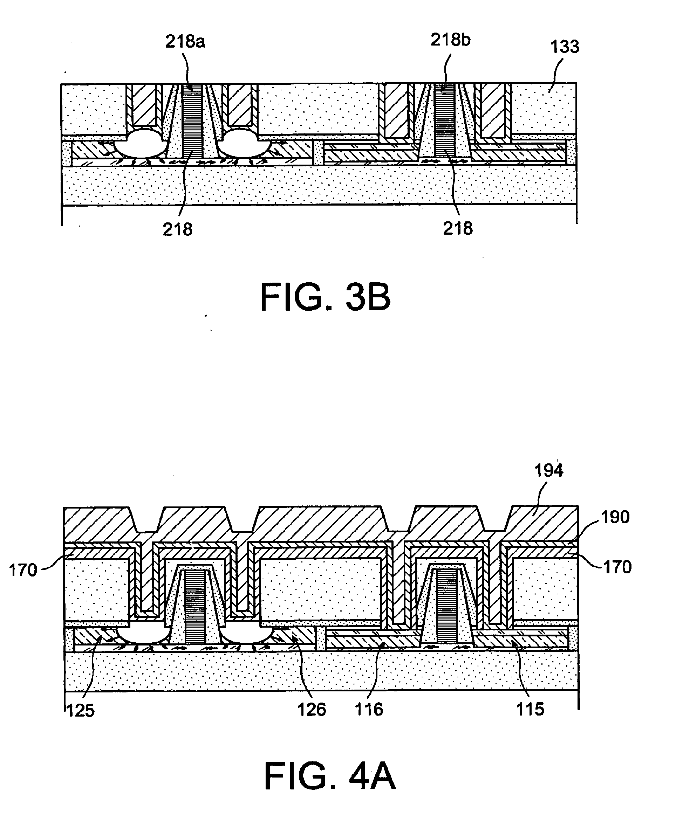

Selon une variante illustrée sur les figures 3A et 3B, une fois les étapes précédemment décrites ont été réalisées, on peut ensuite retirer les grilles 108a et 108b qui, dans ce cas, ont joué le rôle de grilles sacrificielles ou de grilles factices (figure 3A). On remplace ensuite ces grilles sacrificielles ou factices par d'autres grilles 218a et 218b formées en un autre matériau de grille.

Pour cette variante, les grilles sacrificielles 108a, 108b peuvent être formées d'un matériau semi-conducteur, par exemple tel que du polysilicium.

Le remplacement des grilles 108a, 108b peut être effectué par dépôt d'un autre matériau 218 de grille, tel qu'un métal ou un empilement de plusieurs métaux. Cela peut être réalisé par dépôt puis retrait d'un éventuel excédent par polissage mécano-chimique avec arrêt sur la couche de matériau diélectrique 133.

Cette variante de réalisation est effectuée après la formation des zones siliciurées et peut conduire à une redistribution des contraintes préférentiellement au niveau des zones de canal des transistors T1 et T2.

Une autre variante de réalisation est donnée sur les figures 4A-4B.

Pour cette variante, le métal 170 déposé dans les ouvertures 141, 143, 145, 147 pour effectuer une siliciuration des zones semi-conductrices 115, 116, 125, 126, est conservé.

Une couche barrière de diffusion 190, par exemple à base de TaN ou de TiN et d'une épaisseur comprise par exemple entre 1 nm et 10 nm, est ensuite déposée. Puis, un matériau métallique 194 tel que par exemple du tungstène, ou du cuivre est déposé afin de combler les ouvertures 141, 143, 145, 147 (figure 4A).

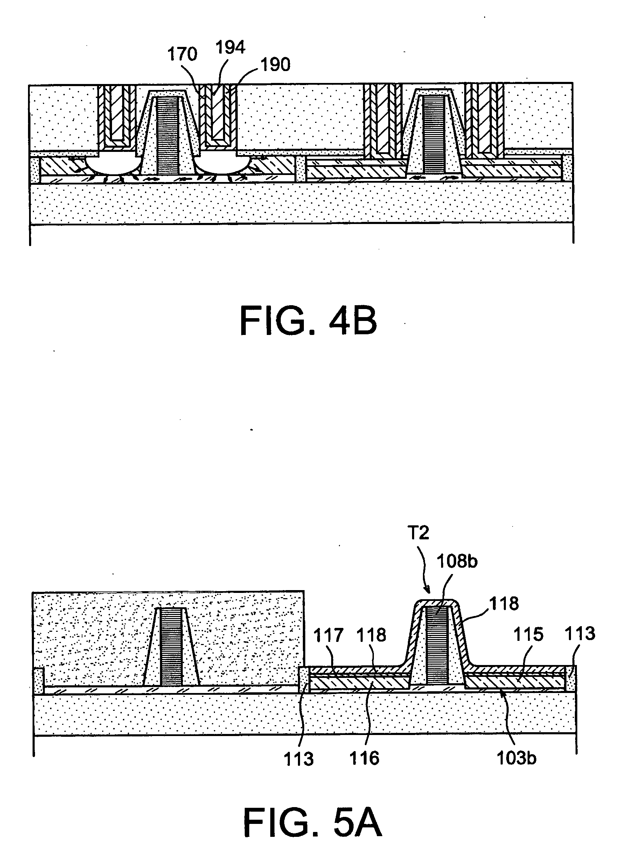

Ensuite, les couches de métal 170, de barrière 190 et de matériau métallique 194 sont ôtées de la surface de la couche de matériau diélectrique par exemple par polissage mécano-chimique avec un arrêt sur le diélectrique (figure 4B).

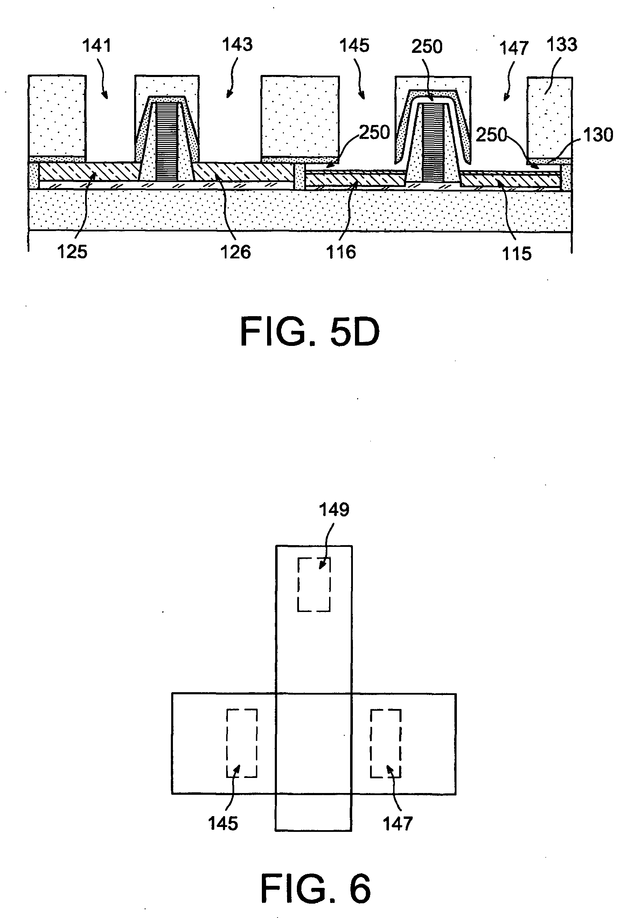

Une variante de l'exemple de procédé qui a été décrit précédemment en liaison avec les figures 2A-2K est donnée sur les figures 5A-5D et 6.

Pour cette variante, la couche sacrificielle 118 est réalisée par dépôt de manière à recouvrir la grille 108b du deuxième transistor T₂.

Le matériau de la couche sacrificielle 118 est également un matériau choisi de manière à pouvoir être gravé sélectivement vis-à-vis de celui de la couche de contrainte, par exemple du polySi ou du polyGe (Figure 5A).

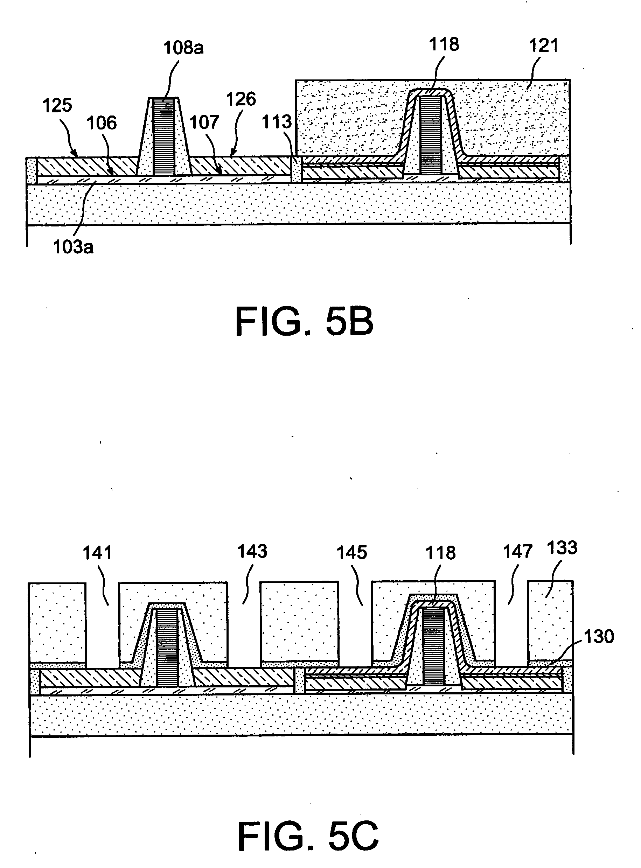

On peut effectuer ensuite les étapes de dépôt d'une couche de masquage, par exemple une couche de masque dur à base de nitrure de silicium, puis de photolithographie et de gravure, peuvent être prévues pour former un autre masque dur 121 recouvrant la deuxième grille 108b ainsi que les zones semi-conductrices 115, 116, tandis que la première grille 108a et la première région semi-conductrice 103a sont quant à elles dévoilées (figure 5B).

Puis, on forme la couche 130 dite « de contrainte », prévue pour exercer une contrainte sur le canal du premier transistor T₁.

La couche 130 de contrainte peut être déposée de manière conforme sur la grille 108a et les zones semi-conductrices 125, 126, du premier transistor T₁, ainsi que la couche sacrificielle 118 réalisée sur le deuxième transistor T₂.

Puis, on forme une couche de matériau diélectrique 133 (figure 5C) dans laquelle on réalise ensuite des ouvertures 141, 143, 145, 147, 149 traversant la couche de contrainte 130, et qui sont destinées à accueillir des plots de contact du premier transistor T₁, et du deuxième transistor T₂. Sur la figure 6, des ouvertures 145, 147, 149 réalisées respectivement en regard d'une région de source, d'une région de drain et d'une région de grille du deuxième transistor T2.

On réalise ensuite un retrait de la couche sacrificelle 118, par exemple par gravure sélective vis-à-vis des couches 130 et 133 à travers les ouvertures 141, 143, 145, 147, 149. Après retrait, un espace 250 ou une cavité 250 est formé(e) entre la couche de contrainte 130 et le deuxième transistor T₂, la couche de contrainte 130 n'étant plus en contact avec une couche recouvrant le deuxième transistor T₂. Ce retrait permet ainsi de libérer la contrainte exercée par la couche de contrainte 130 sur le deuxième transistor T₂ (figure 5D).

## Revendications

1. Procédé de réalisation d'un dispositif microélectronique à transistors comprenant des étapes de :
a) formation d'une couche de contrainte (130) sur un premier bloc de grille (108a) d'un transistor (T1) d'un premier type et sur des premières zones semi-conductrices (125, 126) situées de part et d'autre dudit premier bloc de grille, ainsi que sur un deuxième bloc de grille (108b) d'un transistor (T2) d'un deuxième type et sur des deuxièmes zones semi-conductrices (115, 116) situées de part et d'autre dudit deuxième bloc de grille, **caractérisé par** une couche sacrificielle (118) prévue entre ladite couche de contrainte (130) et lesdites deuxième zones semi-conductrices (115, 116) du transistor (T2) du deuxième type,
b) former des ouvertures (141, 143, 145, 147) traversant la couche de contrainte parmi lesquelles, une ou plusieurs ouvertures données (145, 147) dévoilant la couche sacrificielle (118)
c) retrait de la couche sacrificielle (130) par gravure à travers lesdites ouvertures (145, 147).

2. Procédé selon la revendication 1, dans lequel parmi les ouvertures (141, 143, 145, 147) formées à l'étape b) figurent une ou plusieurs ouvertures (141, 143) dévoilant les premières zones semi-conductrices (125, 126).

3. Procédé selon la revendication 2, le procédé comprenant en outre, après l'étape c), le dépôt d'un matériau métallique (170) à travers lesdites ouvertures (141, 143, 145, 147), suivi d'un recuit, de manière à former des zones (175, 176, 185, 186) d'alliage de métal et de semi-conducteur.

4. Procédé selon la revendication 3, dans lequel le type de matériau métallique déposé, le volume de matériau métallique déposé sur les premières zones semi-conductrices (125, 126), ainsi que la durée du recuit sont choisis de manière à former des premières zones d'alliage de métal et semi-conducteur (185,186) exerçant une contrainte en compression sur une zone de canal dudit transistor (T1) du premier type.

5. Procédé selon l'une des revendications 3 ou 4, dans lequel le retrait de la couche sacrificielle (117) par gravure à travers lesdites ouvertures données (145, 147) conduit à la formation de cavités (151, 152) entre lesdites deuxièmes zones semi-conductrices (115, 116) et ladite couche de contrainte (130),
ledit dépôt métallique et ledit recuit étant réalisés de manière à former des deuxièmes zones d'alliage de métal et de semi-conducteur (175, 176) comblant partiellement lesdites cavités (151, 152), un espace (161) étant conservé entre lesdites deuxièmes zones d'alliage de métal et de semi-conducteur (175, 176) et ladite couche de contrainte (130).

6. Procédé selon l'une des revendications 1 à 5, dans lequel le premier bloc de grille (108a) et le deuxième bloc de grille (108b) reposent sur une couche semi-conductrice (103), les premières zones semi-conductrices (125, 126) et/ou les deuxièmes zones semi-conductrices (115, 116) étant formées par croissance sur ladite couche semi-conductrice.

7. Procédé selon la revendication 6, le procédé comprenant en outre, préalablement à ladite croissance : un amincissement de ladite couche semi-conductrice (103) dans des zones (104, 105) situées de part et d'autres dudit premier bloc de grille (108a) et/ou de dudit deuxième bloc de grille (108b).

8. Procédé selon l'une des revendications 6 ou 7, les premières zones semi-conductrices (125, 126) étant formées d'un matériau semi-conducteur prévu pour contraindre en compression ladite couche semi-conductrice (103) sur laquelle repose ledit premier bloc de grille (108a).

9. Procédé selon l'une des revendications 6 à 8, les deuxièmes zones semi-conductrices (115, 116) étant formées d'un matériau semi-conducteur prévu pour contraindre en tension ladite couche semi-conductrice (103) sur laquelle repose ledit deuxième bloc de grille (108b).

10. Procédé selon l'une des revendications 1 à 8, dans lequel préalablement à l'étape a), des espaceurs isolants (109) sont formés contre ledit premier bloc de grille (108a) et ledit deuxième bloc de grille (108b), ladite couche de contrainte (130) reposant sur lesdits espaceurs (109).

11. Procédé selon l'une des revendications 1 à 10, dans lequel la couche de contrainte (130) est séparée desdites deuxièmes zones semi-conductrices par une couche d'arrêt de gravure (117), le retrait à l'étape c) de la couche sacrificielle (118) par gravure à travers lesdites ouvertures données (145, 147) étant réalisé jusqu'à atteindre ladite couche d'arrêt de gravure (118).

12. Procédé selon l'une des revendications 1 à 11, dans lequel la couche de contrainte (130) est à base d'un matériau diélectrique tel que du nitrure de silicium.

13. Procédé selon l'une des revendications 1 à 12, comprenant en outre entre l'étape a) et l'étape b), des étapes de :
- dépôt d'au moins une couche isolante (133) sur la couche de contrainte (130),
- formation de trous traversant la dite couche isolante et dévoilant ladite couche de contrainte par gravure sélective de ladite couche isolante vis-à-vis de ladite couche de contrainte.

14. Procédé selon l'une des revendications 1 à 13, dans lequel le premier bloc de grille (108a) et/ou ledit deuxième bloc de grille (108b) sont à base d'au moins un matériau sacrificiel, le procédé comprenant en outre, après l'étape c), des étapes de :
- retrait de la couche de contrainte (130) sur ledit premier bloc (108a) de grille et/ou sur ledit deuxième bloc (108b) de grille de manière à dévoiler ledit matériau sacrificiel,
- retrait dudit matériau sacrificiel,
- remplacement dudit matériau sacrificiel par au moins un autre matériau de grille.

15. Dispositif microélectronique à transistors comprenant :
- un premier transistor doté de premières zones semi-conductrices (125, 126) situées de part et d'autre d'un premier bloc de grille (108a), une couche de contrainte (130) disposée sur et en contact avec le premier bloc de grille (108a) et sur les premières zones semi-conductrices (125, 126) de manière à exercer une contrainte mécanique donnée sur le premier transistor,
- un deuxième transistor doté de deuxièmes zones semi-conductrices (115, 116) situées de part et d'autre d'un deuxième bloc de grille, la couche de contrainte (130) étant disposée au dessus du deuxième bloc de grille (108b) et des deuxièmes zones semi-conductrices (125, 126) et **caractérisé par** la couche de contrainte (130) disjointe des deuxièmes zones semi-conductrices (125, 126).

## Patentansprüche

1. Verfahren zur Herstellung einer mikroelektronischen Transistorenvorrichtung, folgende Schritte umfassend:
a) Bilden einer Verspannungsschicht (130) auf einem ersten Gateblock (1 08a) eines Transistors (T1) eines ersten Typs und auf ersten beiderseits des ersten Gateblocks befindlichen halbleitenden Zonen (125, 126), sowie auf einem zweiten Gateblock (1 08b) eines Transistors (T2) eines zweiten Typs und auf zweiten beiderseits des zweiten Gateblocks befindlichen halbleitenden Zonen (115, 116), **gekennzeichnet durch** eine Opferschicht (118), vorgesehen zwischen der genannten Verspannungsschicht (130) und den genannten zweiten halbleitenden Zonen (115, 116) des Transistors (T2) des zweiten Typs,
b) Herstellen von die Verspannungsschicht durchquerenden Öffnungen (141, 143, 145, 147), von denen eine oder mehrere gegebene Öffnungen (145, 147) die Opferschicht (118) freilegen,
c) Entfernen der Opferschicht (130) mittels Ätzung **durch** die genannten Öffnungen (145, 147) hindurch.

2. Verfahren nach Anspruch 1, bei dem unter den in Schritt b) hergestellten Öffnungen (141, 143, 145, 147) eine oder mehrere Öffnungen (141, 143) die ersten Halbleiterzonen (125, 126) freilegen.

3. Verfahren nach Anspruch 2, wobei das Verfahren außerdem nach Schritt c) die Abscheidung eines metallischen Materials (170) durch die genannten Öffnungen (141, 143, 145, 147) hindurch umfasst, gefolgt von einem Tempern, um Metall- und Halbleiterlegierungs-Zonen (175, 176, 185, 186) zu bilden.

4. Verfahren nach Anspruch 3, bei dem der Typ des abgeschiedenen metallischen Materials, das Volumen des auf den ersten Halbleiterzonen (125, 126) abgeschiedenen metallischen Materials sowie die Dauer des Temperns ausgewählt werden, um erste Metall-und Halbleiterlegierungs-Zonen (185, 186) zu bilden, die eine Druckspannung ausüben auf eine Kanalzone des genannten Transistors (T1) des ersten Typs.

5. Verfahren nach einem der Ansprüche 3 oder 4, bei dem die Entfernung der Opferschicht (117) durch Ätzung durch die genannten gegebenen Öffnungen (145, 147) hindurch zur Bildung der Hohlräume (151, 152) zwischen den genannten zweiten Halbleiterzonen (115, 116) und der genannten Verspannungsschicht (130) führt,
wobei die metallische Abscheidung und das genannte Tempern so realisiert werden, dass sich zweite Metall- und Halbleiterlegierungs-Zonen (175, 176) bilden, welche die genannten Hohlräume (151, 152) partiell füllen, wobei zwischen den genannten zweiten Metall- und Halbleiterlegierungs-Zonen (175, 176) und der Verspannungsschicht (130) ein Raum (161) ausgespart bleibt.

6. Verfahren nach einem der Ansprüche 1 bis 5, bei dem der erste Gateblock (108a) und der zweite Gateblock (108b) auf einer Halbleiterschicht (103) ruhen, wobei die ersten Halbleiterzonen (125, 126) und/oder die zweiten Halbleiterzonen (115, 116) durch Aufwachsen auf der genannten Halbleiterschicht gebildet werden.

7. Verfahren nach Anspruch 6, wobei das Verfahren außerdem vor dem genannten Aufwachsen umfasst : eine Dünnung der genannten Halbleiterschicht (103) in den Zonen (104, 105), die sich beiderseits des genannten ersten Gateblocks (108a) und/oder des genannten zweiten Gateblocks (108b) befinden.

8. Verfahren nach einem der Ansprüche 6 oder 7, wobei die ersten Halbleiterzonen (125, 126) aus einem Halbleitermaterial sind, das eine Druckverspannung der genannten Halbleiterschicht (103) bewirkt, auf der der genannte erste Halbleiterblock (108a) ruht.

9. Verfahren nach einem der Ansprüche 6 bis 8, wobei die zweiten Halbleiterzonen (115, 116) aus einem Halbleitermaterial sind, das eine Zugverspannung der genannten Halbleiterschicht (103) bewirkt, auf der der genannte zweite Halbleiterblock (108b) ruht.

10. Verfahren nach einem der Ansprüche 1 bis 8, bei dem vor dem Schritt a) am ersten Gateblock (108a) und dem zweiten Gateblock (108b) isolierende Spacer (109) ausgebildet werden, wobei die Verspannungsschicht (130) auf den genannten Spacern (109) ruht.

11. Verfahren nach einem der Ansprüche 1 bis 10, bei dem die Verspannungsschicht (130) von den genannten zweiten Halbleiterzonen durch eine Ätzsperrschicht (117) getrennt ist, wobei die Entfernung der Opferschicht (118) durch Ätzung durch die genannten bestimmten Öffnungen (145, 147) in Schritt c) bis zum Erreichen der genannten Ätzsperrschicht (118) erfolgt.

12. Verfahren nach einem der Ansprüche 1 bis 11, bei dem die Verspannungsschicht (130) auf einem dielektrischen Material wie etwa Siliciumnitrid basiert.

13. Verfahren nach einem der Ansprüche 1 bis 12, außerdem zwischen dem Schritt a) und dem Schritt b) folgende Schritte umfassend :
- Abscheiden einer Isolierschicht (133) auf der Verspannungsschicht (130),
- Herstellen von die genannte Isolierschicht durchquerenden und die genannte Verspannungsschicht freilegenden Löchern durch gegenüber der Verspannungsschicht selektives Ätzen der genannten Isolierschicht.

14. Verfahren nach einem der Ansprüche 1 bis 13, bei dem der erste Gateblock (108a) und/oder der genannte zweite Gateblock (108b) auf wenistens einem Opfermaterial basieren, wobei das Verfahren außerdem, nach dem Schritt c), folgende Schritte umfasst :
- Entfernen der Verspannungsschicht (130) auf dem ersten Gateblock (108a) und/oder auf dem genannten zweiten Gateblock (108b), um das genannte Opfermaterial frei zu legen,
- Entfernen des genannten Opfermaterials,
- Ersetzen des genannten Opfermaterials durch wenigstens ein anderes Gatematerial.

15. Mikroelektronische Transistorenvorrichtung, umfassend :
- einen ersten Transistor mit beiderseits eines ersten Gateblocks (108a) angeordneten ersten Halbleiterzonen (125, 126), und eine Verspannungsschicht (130), so auf dem ersten Gateblock (108a), und in Kontakt mit diesem, und auf den ersten Halbleiterzonen (125, 126) angeordnet, dass auf den ersten Transistor eine bestimmte mechanische Spannung wirkt,
- einen zweiten Transistor mit beiderseits eines zweiten Gateblocks angeordneten zweiten Halbleiterzonen (115, 116), wobei sich die Verspannungsschicht (130) über dem zweiten Gateblock (108b) und den zweiten Halbleiterzonen (125, 126) befindet, und **gekennzeichnet durch** die von den zweiten Halbleiterzonen (125, 126) getrennte Verspannungsschicht (130).

## Claims

1. A Method for producing a microelectronic device with transistors comprising the steps of:
a) forming a strain layer (130) on a first gate block (108a) of a transistor (T1) of a first type and on first semi-conductor areas (125, 126) situated on either side of said first gate block (108a), as well as on a second gate block of a transistor (T2) of a second type and on second semi-conductor areas (115, 116) situated on either side of said second gate block, **characterized by** a sacrificial layer (118) provided between said strain layer (130) and said second semi-conductor areas (115, 116) of the transistor (T2) of the second type,
b) forming openings (141, 143, 145, 147) traversing the strain layer among which one or more given openings (145, 147) exposing the sacrificial layer (118),
c) removing the sacrificial layer (130) by etching through said openings (145, 147).

2. Method according to claim 1, wherein among the openings (141, 143, 145, 147) formed at step b) one or more openings revealing the first semi-conductor areas.

3. Method according to claim 2, the method moreover comprising, after step c), the deposition of a metallic material (170) through said openings (141, 143, 145, 147), followed by an annealing, so as to form areas (175, 176, 185, 186) of alloy of metal and semi-conductor.

4. Method according to claim 3, wherein the type of metallic material deposited, the volume of metallic material deposited on the first semi-conductor areas (125, 126), as well as the duration of the annealing are chosen so as to form first areas of alloy of metal and semi-conductor (185, 186) exerting a compressive strain on a channel area of said transistor (T1) of the first type.

5. A Method according to claim 3 or 4, wherein the removal of the sacrificial layer (117) by etching through said given openings (145, 147) leads to the formation of cavities (151, 152) between said second semi-conductor areas (115, 116) and said strain layer, said metallic deposition and said annealing being carried out so as to form second areas of alloy of metal and semi-conductor partially filling said cavities, a space being conserved between said second areas of alloy of metal and semi-conductor and said strain layer (130).

6. A Method according to any of the claims 1 to 5, wherein the first gate block (108a) and the second gate block (108b) rest on a semi-conductor layer (103), the first semi-conductor areas (125, 126) and/or the second semi-conductor areas (115, 116) being formed by growth on said semi-conductor layer.

7. A Method according to claim 6, the method moreover comprising, prior to said growth: a thinning of said semi-conductor layer (103) in areas (104, 105) situated on either side of said first gate block (108a) and/or of said second gate block (108b).

8. A Method according to claim 6 or 7, the first semi-conductor areas (125, 126) being formed of a semi-conductor material provided to compressive strain said semi-conductor layer (103) on which said first gate block rests (108a).

9. A Method according to any of the claims 6 to 8, the second semi-conductor areas (115, 116) being formed of a semi-conductor material provided to tensile strain said semi-conductor layer (103) on which said second gate block rests (108b).

10. A Method according to any of the claims 1 to 8, wherein prior to step a), insulating spacers (109) are formed against said first gate block (108a) and said second gate block (108b), said strain layer (130) resting on said spacers (109).

11. A Method according to any of the claims 1 to 10, wherein the strain layer (130) is separated from said second semi-conductor areas by an etching stop layer (117), the removal at step c) of the sacrificial layer (118) by etching through said given openings (145, 147) being carried out until reaching said etching stop layer (118).

12. A Method according to any of the claims 1 to 11, wherein the strain layer (130) is based on a dielectric material such as silicon nitride.

13. A Method according to any of the claims 1 to 12, moreover comprising between step a) and step b), the steps of:
- depositing at least one insulating layer on the strain layer (130),
- forming holes traversing said insulating layer and exposing said strain layer by selective etching of said insulating layer vis-à-vis said strain layer.

14. A Method according to any of the claims 1 to 13, wherein the first gate block (108a) and/or said second gate block (108b) are based on at least one sacrificial material, the method moreover comprising, after step c), the steps of:
- removing the strain layer (130) on said first gate block (108a) and/or on said second gate block (108b) so as to expose said sacrificial material,
- removing said sacrificial material,
- replacing said sacrificial material by at least one other gate material.

15. A Microelectronic device with transistors comprising:
- a first transistor provided with first semi-conductor areas (125, 126) situated on either side of a first gate block (108a), a strain layer (130) laid out on and in contact with the first gate block (108a) and on the first semi-conductor areas (125, 126) so as to exert a given mechanical strain on the first transistor,
- a second transistor provided with second semi-conductor areas (115, 116) situated on either side of a second gate block, the strain layer (130) being laid out above the second gate block (108b) and **characterized by** the strain layer (130) disjointed from the second semi-conductor areas (125, 126).
